# EUROPEAN PATENT APPLICATION

(11) **EP 4 588 657 A1**
(43) Date of publication of application: **23.07.2025**
(21) Application number: 23865592.2
(22) Date of filing: 14.09.2023
(51) Int. Cl.: B32B 27/00, G03F 1/72, G03F 7/20, G01N 21/95, H01L 21/66

(54) **MANUFACTURING METHOD FOR CONDUCTIVE FILM, MANUFACTURING METHOD FOR MASK, MANUFACTURING METHOD FOR SEMICONDUCTOR DEVICE, DEFECT EXAMINATION METHOD FOR CONDUCTIVE FILM, AND DEFECT EXAMINATION DEVICE**

(30) Priority: 14.09.2022 JP 2022146118
(71) Applicant: Mitsubishi Chemical Corporation, Tokyo 100-8251 (JP)
(72) Inventor: KANAME Shunsuke, Tokyo 100-8251 (JP); TAKAHASHI Toshiya, Tokyo 100-8251 (JP)
(74) Representative: Hoffmann Eitle
(86) International application number: PCT/JP2023/033497
(87) International publication number: WO 2024/058243

(57) **Abstract**

According to the present invention, a method is provided for producing a conductive film with high accuracy in defect detection. The production method includes an inspection step of irradiating a conductive film with a laser to inspect a defect of the conductive film, in which in the inspection step, the conductive film is irradiated with a laser having a wavelength at which an attenuation coefficient k of the conductive film is 0.2 or less.

## Description

### TECHNICAL FIELD

The present invention relates to a method for producing a conductive film, a method for producing a mask, a method for producing a semiconductor device, a defect inspection method for a conductive film, and a defect inspection device.

Priority is claimed on Japanese Patent Application No. 2022-146118, filed September 14, 2022, the content of which is incorporated herein by reference.

### BACKGROUND ART

A pattern-forming technique using ionizing radiation such as electron beams or ion beams is expected as a next-generation technique for photolithography. In the production of a semiconductor device, for example, various patterns are formed on a base material such as a wafer by photolithography using a photomask.

When a defect is present on the base material or the photomask, the defect affects the pattern formation, and thus, the inspection of the defect is an important step.

As a defect inspection method, for example, an inspection method using laser irradiation is known.

For example, a laser light source that generates laser beams having a wavelength of 532 nm (see Patent Document 1) or illumination light having a wavelength of 504 nm (see Patent Document 2) is used as a light source of a device that detects a defect of a base material or a mask. With the miniaturization of semiconductors in recent years, short-wavelength light having higher sensitivity for detection of a minute defect has been used.

**In** a pattern-forming method using ionizing radiation, in particular, when a substrate has an insulating property, there is a problem in that the trajectory of the ionizing radiation is bent due to an electric field generated by the charging (charging-up) of the substrate, making it difficult to obtain a desired pattern.

As a means for solving this problem, a technique in which a conductive composition including a conductive polymer is applied onto a surface of a resist layer to form a conductive film and the surface of the resist layer is covered with the conductive film is already known to be effective (see Patent Document 3).

### Citation List

### Patent Documents

Patent Document 1: Japanese Unexamined Patent Application, First Publication No. 2008-268041
Patent Document 2: Japanese Unexamined Patent Application, First Publication No. 2018-198293
Patent Document 3: PCT International Publication No. WO2014/017540

### SUMMARY OF INVENTION

### Technical Problem

However, in the defect inspection methods in the related art, it is difficult to detect a defect in a conductive film.

An object of the present invention is to provide a method for producing a conductive film with high accuracy in defect detection, a method for producing a mask, a method for producing a semiconductor device, a defect inspection method for a conductive film, and a defect inspection device.

### Solution to Problem

As the wavelength of a laser decreases, the laser tends to be scattered when the laser hits a defect such as foreign matter or scratches. Therefore, as described in Patent Documents 1 and 2, a laser having a short wavelength is generally used for detecting a minute defect on a base material or a mask.

However, the present inventors have found that in a conductive film in which a conductive film is formed on a base material, the conductive film absorbs a laser, whereby the laser is less likely to be scattered even when the laser hits a defect, and the defect is less likely to be detected.

Therefore, the present inventors have focused on an attenuation coefficient k of the conductive film, and have thus completed the present invention, based on the idea that when the conductive film is irradiated with a laser having a wavelength at which the attenuation coefficient k is 0.2 or less, the laser is less likely to be absorbed by the conductive film and the defect of the conductive film is likely to be detected.

That is, the present invention has the following aspects.
[1] A method for producing a conductive film, the method comprising:
   an inspection step of inspecting a defect of a conductive film by irradiating the conductive film with a laser,
   wherein in the inspection step, the conductive film is irradiated with a laser having a wavelength at which an attenuation coefficient k of the conductive film is 0.2 or less.
[2] A method for producing a conductive film, the method comprising:
   an inspection step of inspecting a defect of the conductive film by irradiating a conductive film with a laser having a wavelength determined such that an attenuation coefficient k of the conductive film is 0.2 or less.
[3] The method for producing a conductive film according to [1] or [2], the method further comprising:
   a film formation step of forming the conductive film on a base material.
[4] The method for producing a conductive film according to [1] or [2],
   wherein the conductive film is a conductive film formed on a base material.
[5] The method for producing a conductive film according to [3],
   wherein a resist layer is formed on the base material, and
   the film formation step is a step of forming the conductive film on the resist layer.
[6] The method for producing a conductive film according to any one of [1] to [4],
   wherein the conductive film is a conductive film formed on a resist layer of a base material in which the resist layer is formed.
[7] The method for producing a conductive film according to any one of [1] to [6], the method further comprising:
   a determination step of determining the wavelength of the laser with which the conductive film is irradiated, based on the attenuation coefficient k of the conductive film.
[8] The method for producing a conductive film according to [7],
   wherein the determination step is a step of determining the wavelength of the laser using the conductive film irradiated with the laser in the inspection step.
[9] The method for producing a conductive film according to [7],
   wherein the determination step is a step of determining the wavelength of the laser using a conductive film separately produced to have the same formulation as that of the conductive film irradiated with the laser in the inspection step.
[10] The method for producing a conductive film according to any one of [1] to [9],
   wherein the wavelength of the laser is 600 to 1,000 nm.
[11] The method for producing a conductive film according to [10],
   wherein the wavelength of the laser is 700 to 900 nm.
[12] The method for producing a conductive film according to any one of [1] to [11],
   wherein the conductive film includes a conductive polymer having at least one unit selected from the group consisting of units represented by Formulae (1) to (4).

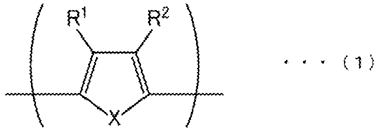

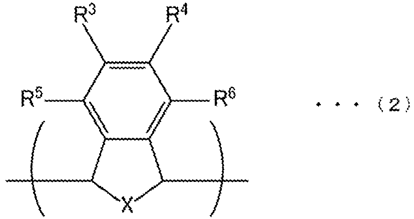

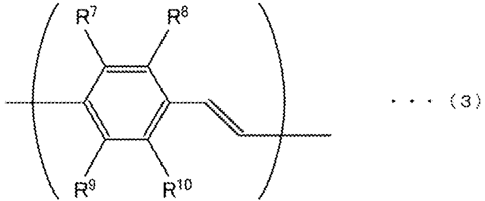

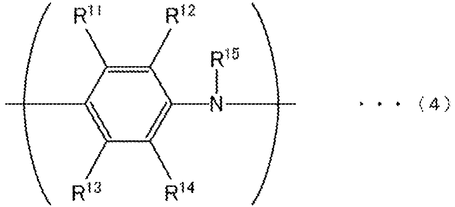

In Formulae (1) to (4), X represents a sulfur atom or a nitrogen atom, and R¹ to R¹⁵ each independently represents a hydrogen atom, a linear or branched alkyl group having 1 to 24 carbon atoms, a linear or branched alkoxy group having 1 to 24 carbon atoms, an acidic group or a salt thereof, a hydroxy group, a nitro group, a halogen atom, - N(R¹⁶)₂, -NHCOR¹⁶, -SR¹⁶, -OCOR¹⁶, -COOR¹⁶, -COR¹⁶, -CHO, or -CN. R¹⁶ represents an alkyl group having 1 to 24 carbon atoms, an aryl group having 6 to 24 carbon atoms, or an aralkyl group having 7 to 24 carbon atoms.

It should be noted that at least one of R¹ and R² in Formula (1), at least one of R³ to R⁶ in Formula (2), at least one of R⁷ to R¹⁰ in Formula (3), and at least one of R¹¹ to R¹⁵ in Formula (4) are each an acidic group or a salt thereof.

[13] The method for producing a conductive film according to any one of [1] to [11],
wherein the conductive film includes a conductive polymer having a unit represented by Formula (4).

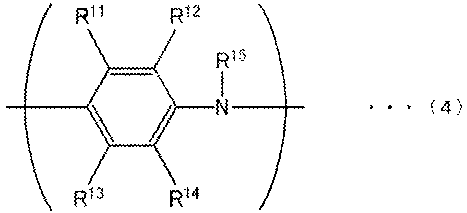

In Formula (4), R¹¹ to R¹⁵ each independently represents a hydrogen atom, a linear or branched alkyl group having 1 to 24 carbon atoms, a linear or branched alkoxy group having 1 to 24 carbon atoms, an acidic group or a salt thereof, a hydroxy group, a nitro group, a halogen atom, -N(R¹⁶)₂, -NHCOR¹⁶, -SR¹⁶, -OCOR¹⁶, -COOR¹⁶, -COR¹⁶, - CHO, or -CN. R¹⁶ represents an alkyl group having 1 to 24 carbon atoms, an aryl group having 6 to 24 carbon atoms, or an aralkyl group having 7 to 24 carbon atoms.

It should be noted that at least one of R¹¹ to R¹⁵ in Formula (4) is an acidic group or a salt thereof.

[14] The method for producing a conductive film according to any one of [1] to [11],
   wherein the conductive film includes a conductive polymer and at least one selected from the group consisting of a basic compound and a surfactant.
[15] The method for producing a conductive film according to any one of [1] to [11],
   wherein the conductive film includes a conductive polymer having at least one unit selected from the group consisting of units represented by Formulae (1) to (4), and at least one selected from the group consisting of a basic compound and a surfactant.

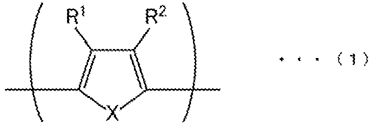

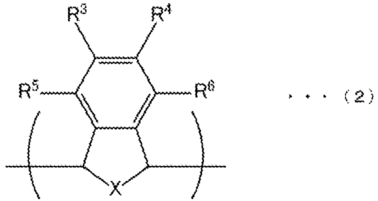

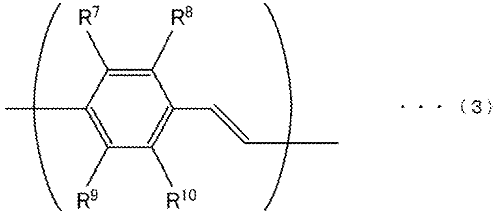

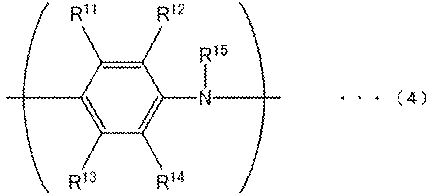

In Formulae (1) to (4), X represents a sulfur atom or a nitrogen atom, and R¹ to R¹⁵ each independently represents a hydrogen atom, a linear or branched alkyl group having 1 to 24 carbon atoms, a linear or branched alkoxy group having 1 to 24 carbon atoms, an acidic group or a salt thereof, a hydroxy group, a nitro group, a halogen atom, - N(R¹⁶)₂, -NHCOR¹⁶, -SR¹⁶, -OCOR¹⁶, -COOR¹⁶, -COR¹⁶, -CHO, or -CN. R¹⁶ represents an alkyl group having 1 to 24 carbon atoms, an aryl group having 6 to 24 carbon atoms, or an aralkyl group having 7 to 24 carbon atoms.

It should be noted that at least one of R¹ and R² in Formula (1), at least one of R³ to R⁶ in Formula (2), at least one of R⁷ to R¹⁰ in Formula (3), and at least one of R¹¹ to R¹⁵ in Formula (4) are each an acidic group or a salt thereof.

[16] The method for producing a conductive film according to any one of [1] to [15],
wherein a film thickness of the conductive film is 1 to 100 nm.

[17] The method for producing a conductive film according to any one of [1] to [16],
wherein a light intensity of the laser is 1 mW to 200 W.

[18] A method for producing a mask blank with a conductive film, the method comprising:
a step of forming a conductive film on a mask blank, which is a base material, using the method for producing a conductive film according to any one of [1] to [17].

[19] A method for producing a mask, the method comprising:
a step of producing a mask blank with a conductive film using the method for producing a conductive film according to [18]; and
a step of producing a mask using the obtained mask blank with a conductive film.

[20] A method for producing a mask, the method comprising:
a step of producing a mask using a mask blank with a conductive film obtained by the method for producing a mask blank with a conductive film according to [18].

[21] A method for producing a mask, the method comprising:
a step of forming a conductive film on a mask blank, which is a base material, using the method for producing a conductive film according to any one of [1] to [17] to produce a mask blank with the conductive film; and
a step of producing a mask using the obtained mask blank with the conductive film.

[22] The method for producing a mask according to any one of [19] to [21], the method further comprising:
a step of inspecting a defect on the mask blank, which is a base material, by laser irradiation after the conductive film has been removed from the mask blank with the conductive film.

[23] The method for producing a mask according to any one of [19] to [21], the method further comprising:
a step of inspecting a defect on a mask blank, which is a base material, obtained by removing the conductive film from the mask blank with a conductive film, by laser irradiation.

[24] A method for producing a semiconductor device, the method comprising:
a step of forming a conductive film on a base material using the method for producing a conductive film according to any one of [3] to [6] to obtain a laminate; and
a step of producing a semiconductor device using the laminate.

[25] A method for producing a semiconductor device, the method comprising:
a step of producing a semiconductor device using a laminate provided with a conductive film obtained by the method for producing a conductive film according to any one of [1] to [17].

[26] The method for producing a semiconductor device according to [25],
wherein the conductive film is a conductive film formed on a base material.

[27] The method for producing a semiconductor device according to [24] or [26], the method further comprising:
a step of inspecting a defect on the base material by laser irradiation after the conductive film has been removed.

[28] The method for producing a semiconductor device according to [24] or [26], the method further comprising:
a step of inspecting a defect on the base material, from which the conductive film has been removed, by laser irradiation.

[29] A defect inspection method for a conductive film, the method comprising:
irradiating a conductive film with a laser having a wavelength at which an attenuation coefficient k of the conductive film is 0.2 or less.

[30] A defect inspection device, comprising:
an irradiation unit that uses a laser having a wavelength at which an attenuation coefficient k of a conductive film is 0.2 or less for a conductive film as a measurement target; and
an inspection unit that analyzes the presence or absence of a defect based on scattered light from the conductive film.

### Advantageous Effects of Invention

According to the present invention, it is possible to provide a method for producing a conductive film with high accuracy in defect detection, a method for producing a mask, and a method for producing a semiconductor device.

### BRIEF DESCRIPTION OF DRAWINGS

[FIG. 1] FIG. 1 is a schematic cross-sectional view of an example of a laminate according to an embodiment of the present invention.
[FIG. 2] FIG. 2 is a schematic cross-sectional view of another example of the laminate of the present invention.

### DESCRIPTION OF EMBODIMENTS

The present invention will be described in detail below. The following embodiments are merely examples describing the present invention but the present invention is not intended to be limited only to these embodiments. The present invention can be carried out in various aspects as long as the various aspects maintain the gist of the invention.

In in the present invention, "conductivity" means having a surface resistivity of 1 x 10¹¹ Ω/□ or less. The surface resistivity is a surface resistance value per unit area (1 cm²) of a test material. The surface resistance value is determined from a potential difference between electrodes when a constant current flows therethrough.

In the present specification, "solubility" means uniform dissolution of 0.1 g or more in 10 g (at a liquid temperature of 25°C) of one or more solvents including simple water, water including at least one of a base and a basic salt, water including an acid, or a mixture of water and a water-soluble organic solvent. "Water-soluble" means solubility in water with respect to the solubility.

In the present specification, a "terminal" of a "terminal hydrophobic group" means a moiety other than the repeating unit constituting the polymer.

In the present specification, "mass-average molecular weight" means the mass-average molecular weight (sodium polystyrene sulfonate-equivalent or polyethylene glycol-equivalent) measured by gel permeation chromatography (GPC).

In the present specification, a numerical value range represented using "to" means a range including the numerical values listed before and after "to" as the lower limit value and the upper limit value.

### [Method for Producing Conductive Film]

An embodiment of the method for producing a conductive film of the present invention will be described.

The method for producing a conductive film of the present embodiment includes an inspection step shown below.

The method for producing a conductive film of the present embodiment may further include a film formation step shown below.

The method for producing a conductive film of the present embodiment may further include a base material preparation step shown below before the film formation step, and may further include a resist layer formation step shown below after the base material preparation step and before the film formation step.

The method for producing a conductive film of the present embodiment may further include a determination step shown below.

### <Laminate>

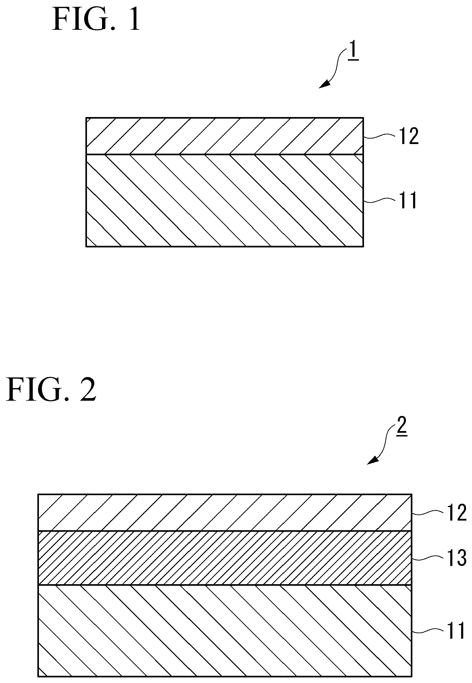

In the method for producing a conductive film of the present embodiment, the conductive film is, for example, a conductive film 12 formed on a surface of a base material 11 in a laminate 1 shown in FIG. 1 in a cross-sectional view or a conductive film 12 formed on a surface of a resist layer 13 on a side opposite the base material 11 in a laminate 2 shown in FIG. 2.

The laminate 1 shown in FIG. 1 is a laminate provided with the base material 11 and the conductive film 12.

The laminate 1 provided with the conductive film 12 on the base material 11 can be prepared by, for example, a base material preparation step and a film formation step, which will be described later.

The laminate 2 shown in FIG. 2 is a laminate provided with the base material 11, the resist layer 13, and the conductive film 12, in which the resist layer 13 is formed on the base material 11, and the conductive film 12 is formed on a side of the resist layer 13 opposite the base material 11 side.

The laminate 2 provided with the resist layer 13 and the conductive film 12 on the base material 11 can be prepared by, for example, a base material preparation step, a resist layer formation step, and a film formation step, which will be described later.

### <Base Material Preparation Step>

The base material preparation step is a step of preparing a base material which is a base part of a conductive film.

Examples of the base material include polyester resins such as polyethylene terephthalate (PET) and polybutylene terephthalate (PBT), polyolefin resins typified by polyethylene and polypropylene, vinyl chloride, nylon, polystyrene, polycarbonate, epoxy resins, fluororesins, polysulfone, polyimide, silicone resins, polyurethane, phenol resins, and molded articles and films of these polymer compounds such as synthetic paper; paper, iron, glass, quartz glass, various wafers, various mask blanks, aluminum, copper, zinc, nickel, and stainless steel; base materials whose surfaces are coated with various paints, photosensitive resins, or the like.

The shape of the substrate is not particularly limited and may be plate-like or a non-plate-like shape.

### <Resist Layer Formation Step>

The resist layer formation step is a step of forming a resist layer on a base material.

In the present invention, the base material on which the resist layer is formed is also referred to as a "base material with a resist layer".

The resist layer is obtained by applying a resist onto a base material.

Examples of the resist include a positive tone resist and a negative tone resist.

The positive tone resist is not particularly limited as long as it is sensitive to ionizing radiation and a known resist can be used. Typical examples thereof include a chemical amplification type resist which contains an acid generator that generates an acid upon irradiation with ionizing radiation and a polymer that includes a constitutional unit having an acid-decomposable group.

The negative tone resist is not particularly limited as long as it is sensitive to ionizing radiation and a known resist can be used. Typical examples thereof include a chemical amplification type resist which contains an acid generator that generates an acid upon irradiation with ionizing radiation, a polymer that is soluble in a developer, and a crosslinking agent.

The resist layer can be formed by a known method. For example, an organic solvent solution of a positive tone or negative tone resist is applied onto one surface of the base material, and subjected to heating (pre-baking) as necessary to form a positive tone or negative tone resist layer.

The method for applying the resist is the same as the method for applying a conductive composition, which will be described later.

The film thickness of the resist layer is not particularly limited, but is, for example, preferably 50 to 200 nm, and more preferably 70 to 150 nm.

### <Film Formation Step>

The film formation step is a step of forming a conductive film on a base material or a resist layer before an inspection step for the conductive film, which will be described later; and preparing the conductive film which is an object to be inspected in the inspection step.

The conductive film is obtained by applying a conductive composition onto a base material or a resist layer and drying the conductive composition. A heating treatment may be performed as necessary on the conductive composition after drying.

When a resist layer is formed on a base material, a conductive film is formed on the resist layer of the base material with the resist layer.

When the resist layer is not formed on the base material, the conductive film is formed directly on a surface of the base material.

The conductive film is preferably a conductive film formed on a base material or a conductive film formed on a resist layer of a base material with a resist layer.

The film thickness of the conductive film is usually 1 to 100 nm. The film thickness is preferably 10 to 80 nm, and more preferably 10 to 60 nm from the viewpoint of accurate pattern formation.

The upper limit of the film thickness is preferably 80 nm, more preferably 60 nm, and still more preferably 50 nm.

The lower limit of the film thickness is preferably 5 nm, more preferably 10 nm, and still more preferably 15 nm.

Examples of the method for applying the conductive composition include methods such as a spin coating method, a spray coating method, a dip coating method, a roll coating method, a gravure coating method, a reverse coating method, a roll brushing method, an air knife coating method, and a curtain coating method.

The drying temperature when drying the conductive composition is not particularly limited, but is preferably lower than 40°C. The drying time when drying the conductive composition is not particularly limited, but is preferably within 1 hour.

When the conductive composition is dried and then subjected to a heating treatment, the heating treatment temperature is preferably in a temperature range of 40°C to 250°C, and more preferably in a temperature range of 60°C to 200°C from the viewpoint of conductivity. The heating treatment time is preferably within 1 hour, and more preferably within 30 minutes from the viewpoint of stability.

The film thickness of the conductive film is preferably 1 to 100 nm, more preferably 5 to 50 nm, and still more preferably 5 to 30 nm.

The details of the conductive composition will be described later.

### <Determination Step>

The determination step is a step of determining a wavelength of the laser with which the conductive film is irradiated, based on an attenuation coefficient k of the conductive film. The determination step may be performed before or after the inspection step, which will be described later.

In the determination step, first, for example, a value of the attenuation coefficient k of the conductive film having a wavelength of 200 to 1,000 nm is acquired.

The attenuation coefficient k of the conductive film can be measured using an ellipsometer.

The measurement method using an ellipsometer is a method in which optical characteristics of an object to be measured are measured by measuring a change in the polarization state during light reflection on a surface of a substance. As a specific measurement method, a rotating analyzer method in which an analyzer is rotated to observe a polarization state of reflected light, a phase modulation method in which a polarization state of reflected light is observed by the action of a photoelastic modulator, and the like are known.

Next, the wavelength at which the attenuation coefficient k of the conductive film is 0.2 or less is confirmed, and the wavelength of the laser is determined such that the wavelength at which the attenuation coefficient k is 0.2 or less and the wavelength of the laser used in the inspection step, which will be described later, are the same value.

In the determination step, the attenuation coefficient k may be measured using a conductive film to be irradiated with a laser in the inspection step, which will be described later, and the wavelength of the laser with which the conductive film is irradiated may be determined. A conductive film may be separately produced such that it has the same formulation as that of the conductive film to be actually irradiated with a laser in the inspection step, and the attenuation coefficient k may be measured using the separately produced conductive film, thereby determining a wavelength of the laser with which the conductive film is irradiated. The film thickness of the conductive film when a conductive film is separately produced is, for example, 30 nm.

### <Inspection Step>

The inspection step is a step of irradiating a conductive film with a laser to inspect a defect of the conductive film. The inspection step can be performed on any or all of the conductive films. Hereinafter, the present step is also referred to as a "first inspection step".

In the present invention, a "defect of the conductive film" is, for example, a defect that occurs when a conductive film is formed on a base material or a resist layer. A "defect on the base material", which will be described later, is a defect derived from the base material, a defect generated when a resist layer is formed on the base material, a defect generated when a conductive film is formed on the resist layer, a defect generated when the conductive film is removed from the resist layer, a defect generated when the resist layer is removed from the base material, or the like.

A "defect" is an attachment, a protrusion, a scratch, or the like, which is attached to the base material, the resist layer, or the conductive film.

In the inspection step, the conductive film is irradiated with a laser having a wavelength at which the attenuation coefficient k of the conductive film is 0.2 or less. That is, the attenuation coefficient k of the conductive film at the wavelength of the laser with which the conductive film is irradiated is 0.2 or less.

When the conductive film is irradiated with a laser having a wavelength at which the attenuation coefficient k of the conductive film is 0.2 or less, the conductive film is less likely to absorb the laser. Thus, when a defect is present in the conductive film, the laser incident on the defect is likely to be scattered and the defect in the conductive film is likely to be detected.

The wavelength of the laser is not particularly limited as long as it is a wavelength at which the attenuation coefficient k of the conductive film is 0.2 or less, but is preferably a wavelength at which the attenuation coefficient k is 0.17 or less, more preferably a wavelength at which the attenuation coefficient k is 0.15 or less, still more preferably a wavelength at which the attenuation coefficient k is 0.10 or less, and particularly preferably a wavelength at which the attenuation coefficient k is 0.05 or less.

The wavelength of the laser is preferably a wavelength at which the attenuation coefficient k of the conductive film is 0 to 0.2, preferably a wavelength at which the attenuation coefficient k of the conductive film is 0.001 to 0.2, more preferably a wavelength at which the attenuation coefficient k of the conductive film is 0.001 to 0.17, still more preferably a wavelength at which the attenuation coefficient k of the conductive film is 0.001 to 0.15, particularly preferably a wavelength at which the attenuation coefficient k of the conductive film is 0.001 to 0.10, and particularly preferably a wavelength at which the attenuation coefficient k of the conductive film is 0.001 to 0.05.

In particular, the wavelength of the laser is preferably 600 to 1,000 nm, and more preferably 700 to 900 nm from the viewpoint of suppressing the absorption of the conductive film by the irradiation light.

The light intensity of the laser is preferably 1 mW to 200 W, more preferably 1 mW to 100 W, still more preferably 1 mW to 10 W, and particularly preferably 1 mW to 1 W from the viewpoint of improving the inspection accuracy.

Examples of the laser with which the conductive film is irradiated include a semiconductor laser (266 nm, 355 nm, 532 nm), an excimer laser (193 nm, 248 nm), an argon laser (488 nm), a green laser (520 nm), a red laser (660 nm), an He-Ne laser (633 nm), a ruby laser (694 nm), and a near-infrared fiber laser (785 nm).

An aspect of the present invention is a defect inspection method for a conductive film, in which the conductive film is irradiated with a laser having a wavelength at which an attenuation coefficient k of the conductive film is 0.2 or less.

Another aspect of the present invention is a defect inspection device provided with an irradiation unit that uses a conductive film for a conductive film as a measurement target and emits laser having a wavelength at which an attenuation coefficient k of the conductive film is 0.2 or less, and an inspection unit that analyzes the presence or absence of a defect based on scattered light from the conductive film.

An analysis means in the inspection unit can use a known means.

Specifically, any defect of the conductive film is detected as follows.

First, the conductive film is irradiated with a laser having a specific wavelength.

When a defect is present in the conductive film, the laser which has hit the defect is scattered.

By detecting the scattered laser with a detector, any defect of the conductive film is detected.

### <Conductive Composition>

The conductive composition is a composition including a conductive polymer (A) and a solvent (D), each shown below. The conductive composition may further include at least one selected from the group consisting of a basic compound (B) and a surfactant (C), each shown below, in addition to the conductive polymer (A) and the solvent (D). The conductive composition may further include a component (optional component) other than the conductive polymer (A), the solvent (D), and at least one selected from the group consisting of the basic compound (B) and the surfactant (C). That is, the conductive film is a film including the conductive polymer (A). The conductive film may further include at least one selected from the group consisting of the basic compound (B) and the surfactant (C) in addition to the conductive polymer (A), or may further include optional components in addition to the conductive polymer (A) and at least one selected from the group consisting of the basic compound (B) and the surfactant (C).

### (Conductive Polymer (A))

As the conductive polymer (A), known polymers can be used, and examples thereof include polythiophene, polythiophene vinylene, poly(3-alkylthiophene), poly(3,4-ethylenedioxy)thiophene (PEDOT), poly3,4ethylenedioxythiophene-polystyrenesulfonic acid (PEDOT-PSS), polyaniline, polypyrrole, polytellurophene, polyparaphenylene, polyparaphenylenevinylene, polyacene, and polyacetylene.

The conductive polymer (A) is preferably water-soluble or water-dispersible.

When the conductive polymer (A) is water-soluble or water-dispersible, the coating property of the conductive composition is improved and a conductive film having a uniform thickness is easily obtained.

The conductive polymer (A) preferably has an acidic group or a salt thereof. When the conductive polymer (A) has an acidic group or a salt thereof, the water solubility of the conductive polymer (A) is increased.

The conductive polymer (A) may have two kinds of acidic groups in one molecule. Some or all of the acidic groups may form salts.

As the conductive polymer (A) having an acidic group or a salt thereof, for example, the conductive polymers shown in Japanese Unexamined Patent Application, First Publication No. S61-197633, Japanese Unexamined Patent Application, First Publication No. S63-39916, Japanese Unexamined Patent Application, First Publication No. H1-301714, Japanese Unexamined Patent Application, First Publication No. H5-504153, Japanese Unexamined Patent Application, First Publication No. H5-503953, Japanese Unexamined Patent Application, First Publication No. H4-32848, Japanese Unexamined Patent Application, First Publication No. H4-328181, Japanese Unexamined Patent Application, First Publication No. H6-145386, Japanese Unexamined Patent Application, First Publication No. H6-56987, Japanese Unexamined Patent Application, First Publication No. H5-226238, Japanese Unexamined Patent Application, First Publication No. H5-178989, Japanese Unexamined Patent Application, First Publication No. H6-293828, Japanese Unexamined Patent Application, First Publication No. H7-118524, Japanese Unexamined Patent Application, First Publication No. H6-32845, Japanese Unexamined Patent Application, First Publication No. H6-87949, Japanese Unexamined Patent Application, First Publication No. H6-256516, Japanese Unexamined Patent Application, First Publication No. H7-41756, Japanese Unexamined Patent Application, First Publication No. H7-48436, Japanese Unexamined Patent Application, First Publication No. H4-268331, Japanese Unexamined Patent Application, First Publication No. 2014-65898, or the like are preferable from the viewpoint of solubility.

Examples of the conductive polymer (A) include a π-conjugated conductive polymer including at least one repeating unit selected from the group consisting of phenylene vinylene, vinylene, thienylene, pyrrolylene, phenylene, iminophenylene, isothianaphtene, furylene, and carbazolylene, the α-position or β-position of which is each substituted with at least one group selected from the group consisting of a sulfonic acid group and a carboxy group.

When the π-conjugated conductive polymer includes at least one repeating unit selected from the group consisting of iminophenylene and carbazolylene, examples of the conductive polymer include a conductive polymer having an acidic group or a salt thereof on a nitrogen atom of the repeating unit, and a conductive polymer having an alkyl group substituted with an acidic group or a salt thereof or an alkyl group containing an ether bond on the nitrogen atom.

Among these, a conductive polymer having, as a monomer unit, at least one selected from the group consisting of thienylene, pyrrolylene, iminophenylene, phenylenevinylene, carbazolylene, and isothianaphthene, the β-position of which is substituted with an acidic group or a salt thereof, is preferably used from the viewpoint of conductivity and solubility.

As the conductive polymer (A), among the above-described polymers, at least one selected from the group consisting of polyaniline having an acidic group or a salt thereof, PEDOT, PEDOT-PSS, polypyrrole, and polythiophene is preferable from the viewpoint of excellent conductivity. Among these, in particular, a polyaniline having an acidic group or a salt thereof is particularly suitable as the conductive polymer since it is a compound having excellent solubility in water.

Examples of the polyaniline having an acidic group or a salt thereof include a polymer having an acidic group or a salt thereof on a skeleton of a π-conjugated polymer such as unsubstituted or substituted polyaniline or polydiaminoanthraquinone or on a nitrogen atom in the π-conjugated polymer. Among these, a conductive polymer having at least one unit selected from the group consisting of units represented by Formulae (1) to (4) is preferable, and a conductive polymer containing 20% to 100% by mole of the unit in all the units (100% by mole) constituting the conductive polymer is more preferable from the viewpoint that high conductivity and solubility can be exhibited.

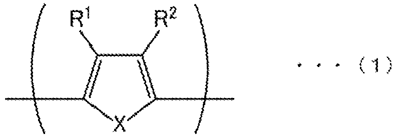

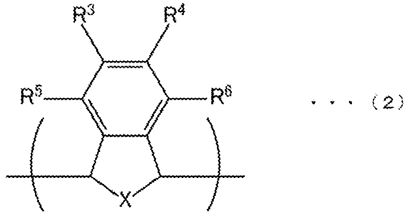

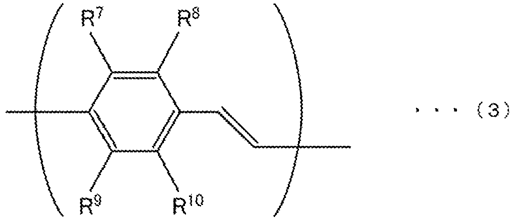

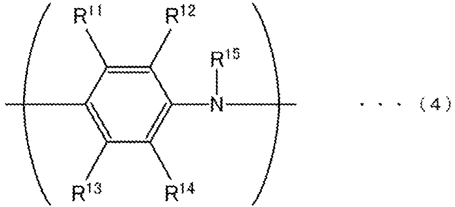

In Formulae (1) to (4), X represents a sulfur atom or a nitrogen atom, and R¹ to R¹⁵ each independently represents a hydrogen atom, a linear or branched alkyl group having 1 to 24 carbon atoms, a linear or branched alkoxy group having 1 to 24 carbon atoms, an acidic group or a salt thereof, a hydroxy group, a nitro group, a halogen atom (-F, -Cl, -Br, or -I), -N(R¹⁶)₂, -NHCOR¹⁶, -SR¹⁶, -OCOR¹⁶, -COOR¹⁶, -COR¹⁶, -CHO, or - CN. R¹⁶ represents an alkyl group having 1 to 24 carbon atoms, an aryl group having 6 to 24 carbon atoms, or an aralkyl group having 7 to 24 carbon atoms.

It should be noted that at least one of R¹ and R² in Formula (1), at least one of R³ to R⁶ in Formula (2), at least one of R⁷ to R¹⁰ in Formula (3), and at least one of R¹¹ to R¹⁵ in Formula (4) are each an acidic group or a salt thereof.

Here, "acid group" means a sulfonic acid group (sulfo group) or a carboxylic acid group (carboxy group).

The sulfonic acid group may be included in an acid state (-SO₃H) or may be contained in an ionic state (-SO₃⁻). The sulfonic acid group also includes a substituent having a sulfonic acid group (-R¹⁷SO₃H).

On the other hand, the carboxylic acid group may be included in an acidic state (-COOH) or may be included in an ionic state (-COO⁻). The carboxylic acid group also includes a substituent having a carboxylic acid group (-R¹⁷COOH).

R¹⁷ represents a linear or branched alkylene group having 1 to 24 carbon atoms, a linear or branched arylene group having 6 to 24 carbon atoms, or a linear or branched aralkylene group having 7 to 24 carbon atoms.

As the acidic group, the sulfonic acid group is preferable.

Examples of the salt of the acidic group include alkali metal salts, alkaline earth metal salts, ammonium salts, or substituted ammonium salts of a sulfonic acid group or carboxylic acid group.

Examples of the alkali metal salts include lithium sulfate, lithium carbonate, lithium hydroxide, sodium sulfate, sodium carbonate, sodium hydroxide, potassium sulfate, potassium carbonate, potassium hydroxide, and derivatives having skeletons thereof.

Examples of the alkaline earth metal salts include a magnesium salt and a calcium salt.

Examples of the quaternary ammonium salts include aliphatic ammonium salts, saturated alicyclic ammonium salts, and unsaturated alicyclic ammonium salts.

Examples of the aliphatic ammonium salts include methyl ammonium, dimethyl ammonium, trimethyl ammonium, ethyl ammonium, diethyl ammonium, triethyl ammonium, methyl ethyl ammonium, diethyl methyl ammonium, dimethyl ethyl ammonium, propylammonium, dipropylammonium, isopropylammonium, diisopropylammonium, butylammonium, dibutylammonium, methylpropylammonium, ethylpropylammonium, methylisopropylammonium, ethylisopropylammonium, methylbutylammonium, ethylbutylammonium, tetramethylammonium, tetramethylolammonium, tetraethylammonium, tetra-n-butylammonium, tetra-sec-butylammonium, and tetra t-butylammonium.

Examples of the saturated alicyclic ammonium salts include piperidinium, pyrrolidinium, morpholinium, piperazinium, and derivatives having skeletons thereof.

Examples of the unsaturated alicyclic ammonium salts include pyridinium, α-picolinium, β-picolinium, γ-picolinium, quinolinium, isoquinolinium, pyrrolinium, and derivatives having skeletons thereof.

From the viewpoint that high conductivity can be exhibited, it is preferable that the conductive polymer (A) have the unit represented by Formula (4), and above all, particularly from the viewpoint of being also excellent in solubility, it is more preferable that the conductive polymer (A) have the unit represented by Formula (5).

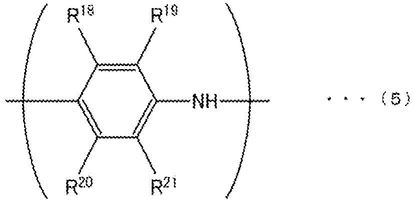

In Formula (5), R¹⁸ to R²¹ each independently represents a hydrogen atom, a linear or branched alkyl group having 1 to 24 carbon atoms, a linear or branched alkoxy group having 1 to 24 carbon atoms, an acidic group or a salt thereof, a hydroxy group, a nitro group, or a halogen atom (-F, -Cl, -Br, or -I). At least one of R¹⁸ to R²¹ is an acidic group or a salt thereof.

As the unit represented by Formula (5), it is preferable that any one of R¹⁸ to R²¹ be a linear or branched alkoxy group having 1 to 4 carbon atoms, another one be a sulfonic acid group or a salt thereof, and the remaining be a hydrogen atom from the viewpoint of ease of production.

From the viewpoints of excellent solubility in water and an organic solvent regardless of pH, the conductive polymer (A) preferably contains 10% to 100% by mole of the unit represented by Formula (5), more preferably contains 50% to 100% by mole, and particularly preferably contains 100% by mole in all the units (100% by mole) constituting the conductive polymer (A).

The conductive polymer (A) preferably contains 10 or more of the units represented by Formula (5) in one molecule from the viewpoint of excellent conductivity.

In the conductive polymer (A), from the viewpoint of further improving the solubility, the number of aromatic rings to which an acidic group or a salt thereof is bonded with respect to the total number of aromatic rings in the polymer is preferably 50% or more, more preferably 70% or more, still more preferably 80% or more, particularly preferably 90% or more, and most preferably 100%.

The number of aromatic rings to which the acidic group or a salt thereof is bonded with respect to the total number of aromatic rings in the polymer refers to a value calculated from the charging ratio of the monomer during the production of the conductive polymer (A).

In the conductive polymer (A), from the viewpoint of imparting reactivity to a monomer, a substituent other than the acidic group or a salt thereof on the aromatic ring of the monomer unit is preferably an electron-donating group, and specifically, the substituent is preferably an alkyl group having 1 to 24 carbon atoms, an alkoxy group having 1 to 24 carbon atoms, a halogen group (-F, -Cl, -Br, or -I), or the like. Among these, from the viewpoint of electron-donating properties, an alkoxy group having 1 to 24 carbon atoms is most preferable as the substituent.

The conductive polymer (A) may include, as a constitutional unit other than the unit represented by Formula (5), one or more units selected from the group consisting of aniline, thiophene, pyrrole, phenylene, vinylene, a divalent unsaturated group, and a divalent saturated group, which is substituted or unsubstituted, as long as the solubility, the conductivity, and the properties are not affected.

From the viewpoint that high conductivity and solubility can be exhibited, the conductive polymer (A) is preferably a compound having a structure represented by Formula (6), and among the compounds having the structure represented by Formula (6), from the viewpoint of particularly excellent solubility, poly(2-sulfo-5-methoxy-1,4-iminophenylene) and poly(2-methoxyaniline-5-sulfonic acid) are particularly preferable.

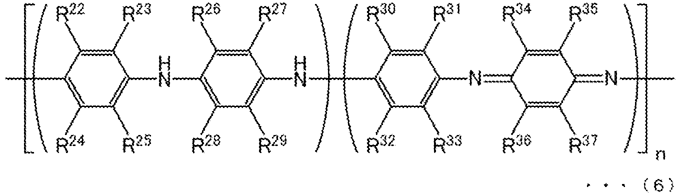

In Formula (6), R²² to R³⁷ each independently represents a hydrogen atom, a linear or branched alkyl group having 1 to 4 carbon atoms, a linear or branched alkoxy group having 1 to 4 carbon atoms, an acidic group or a salt thereof, a hydroxy group, a nitro group, or a halogen atom (-F, -Cl, -Br, or -I). At least one of R²² to R³⁷ is an acidic group or a salt thereof. n represents a degree of polymerization. In the present invention, n is preferably an integer of 5 to 2,500.

As the unit represented by Formula (6), from the viewpoint of ease of the production, it is preferable that any one of R²² to R²⁵ be a linear or branched alkoxy group having 1 to 4 carbon atoms, another be a sulfonic acid group or a salt thereof, and the remaining be a hydrogen atom, any one of R²⁶ to R²⁹ be a linear or branched alkoxy group having 1 to 4 carbon atoms, another be a sulfonic acid group or a salt thereof, and the remaining be a hydrogen atom, any one of R³⁰ to R³³ be a linear or branched alkoxy group having 1 to 4 carbon atoms, another be a sulfonic acid group or a salt thereof, and the remaining be a hydrogen atom, and any one of R³⁴ to R³⁷ be a linear or branched alkoxy group having 1 to 4 carbon atoms, another be a sulfonic acid group or a salt thereof, and the remaining be a hydrogen atom.

From the viewpoint of improving the conductivity, it is desirable that at least some of the acidic groups contained in the conductive polymer (A) be of a free acid type.

The mass-average molecular weight of the conductive polymer (A), in terms of GPC sodium polystyrene sulfonate equivalent, is preferably 1,000 to 1,000,000, more preferably 1,500 to 800,000, still more preferably 2,000 to 500,000, and particularly preferably 2,000 to 100,000 from the viewpoint of the conductivity, solubility, and film-forming properties thereof. When the mass-average molecular weight of the conductive polymer (A) is less than 1,000, the solubility is excellent, but the conductivity and the film-forming properties may be lacking. On the other hand, when the mass-average molecular weight exceeds 1,000,000, the conductivity is excellent, but the solubility may be insufficient.

Here, "film-forming property" refers to a property of forming a uniform film without cissing or the like, and can be evaluated by a method such as spin coating on glass.

The conductive polymer (A) is obtained by, for example, polymerizing raw material monomers of the conductive polymer (A) in the presence of a polymerization solvent and an oxidizing agent.

An example of a method for producing the conductive polymer (A) will be described below.

The method for producing the conductive polymer (A) of the present embodiment includes a step of polymerizing raw material monomers of the conductive polymer (A) of the present embodiment in the presence of a polymerization solvent and an oxidizing agent (polymerization step). The method for producing the conductive polymer (A) of the present embodiment may include a step of purifying a reaction product obtained in the polymerization step (purification step).

### <<Polymerization Step>>

The polymerization step is a step of polymerizing raw material monomers of the conductive polymer (A) in the presence of a polymerization solvent and an oxidizing agent.

Specific examples of the raw material monomer include a polymerizable monomer from which the above-described monomer unit is derived, and specifically include at least one selected from the group consisting of an acidic group-substituted aniline, an alkali metal salt thereof, an alkaline earth metal salt thereof, an ammonium salt thereof, and a substituted ammonium salt thereof.

Examples of the acidic group-substituted aniline include a sulfonic acid group-substituted aniline having a sulfonic acid group as an acidic group.

Representative examples of the sulfonic acid group-substituted aniline include aminobenzenesulfonic acids, and specifically, o-, m-, or p-aminobenzenesulfonic acid, aniline-2,6-disulfonic acid, aniline-2,5-disulfonic acid, aniline-3,5-disulfonic acid, aniline-2,4-disulfonic acid, aniline-3,4-disulfonic acid, or the like is preferably used.

Examples of the sulfonic acid group-substituted anilines other than the aminobenzenesulfonic acids include alkyl group-substituted aminobenzenesulfonic acids such as methylaminobenzenesulfonic acid, ethylaminobenzenesulfonic acid, n-propylaminobenzenesulfonic acid, iso-propylaminobenzenesulfonic acid, n-butylaminobenzenesulfonic acid, sec-butylaminobenzenesulfonic acid, and t-butylaminobenzenesulfonic acid; alkoxy group-substituted aminobenzenesulfonic acids such as methoxyaminobenzenesulfonic acid, ethoxyaminobenzenesulfonic acid, and propoxyaminobenzenesulfonic acid; hydroxy group-substituted aminobenzenesulfonic acids; nitro group-substituted aminobenzenesulfonic acids; and halogen-substituted aminobenzenesulfonic acids such as fluoroaminobenzenesulfonic acid, chloraminobenzenesulfonic acid, and bromaminobenzenesulfonic acid.

Among these, from the viewpoint of obtaining a conductive polymer (A) having particularly excellent conductivity and solubility, the alkyl group-substituted aminobenzenesulfonic acids, the alkoxy group-substituted aminobenzenesulfonic acids, the hydroxy group-substituted aminobenzenesulfonic acids, or the halogen-substituted aminobenzenesulfonic acids are preferable, and from the viewpoint of ease of production, the alkoxy group-substituted aminobenzenesulfonic acids, the alkali metal salts thereof, ammonium salts thereof, or the substituted ammonium salts thereof are particularly preferable.

Any one of these sulfonic acid group-substituted anilines may be used alone or two or more kinds thereof may be mixed in any proportion and used.

Examples of the polymerization solvent include water, an organic solvent, and a mixed solvent of water and the organic solvent.

Examples of the water include tap water, ion exchange water, pure water, and distilled water.

Examples of the organic solvent include alcohols such as methanol, ethanol, isopropyl alcohol, propyl alcohol, and butanol; ketones such as acetone and ethyl isobutyl ketone; ethylene glycols such as ethylene glycol and ethylene glycol methyl ether; propylene glycols such as propylene glycol, propylene glycol methyl ether, propylene glycol ethyl ether, propylene glycol butyl ether, and propylene glycol propyl ether; amides such as N,N-dimethylformamide and N,N-dimethylacetamide; and pyrrolidones such as N-methylpyrrolidone and N-ethylpyrrolidone.

As the polymerization solvent, water or a mixed solvent of water and the organic solvent is preferable.

When a mixed solvent of water and the organic solvent is used as the polymerization solvent, the mass ratio (water/organic solvent) is preferably 1/100 to 100/1 and more preferably 2/100 to 100/2.

The oxidizing agent is not limited as long as it is an oxidizing agent having a standard electrode potential of 0.6 V or more, and examples thereof include peroxodisulfates such as peroxodisulfuric acid, ammonium peroxodisulfate, sodium peroxodisulfate, and potassium peroxodisulfate; and hydrogen peroxide.

Any one of these oxidizing agents may be used alone, or two or more kinds thereof may be mixed in any proportion and used.

In addition to the polymerization solvent and the oxidizing agent, the raw material monomers may be polymerized in the presence of a basic reaction aid in the polymerization step.

Examples of the basic reaction aid include inorganic bases such as sodium hydroxide, potassium hydroxide, and lithium hydroxide; ammonia; fatty amines such as methylamine, dimethylamine, trimethylamine, ethylamine, diethylamine, triethylamine, ethyl methylamine, ethyl dimethylamine, and diethyl methylamine; cyclic saturated amines; and cyclic unsaturated amines such as pyridine, α-picoline, β-picoline, γ-picoline, and quinoline.

Among these, inorganic bases, fatty amines, and cyclic unsaturated amines are preferable, and cyclic unsaturated amines are more preferable.

Any one of these basic reaction aids may be used alone, or two or more kinds thereof may be mixed in any proportion and used.

Examples of the polymerization method include a method in which a raw material monomer solution is added dropwise to an oxidizing agent solution, a method in which an oxidizing agent solution is added dropwise to a raw material monomer solution, and a method in which a raw material monomer solution and an oxidizing agent solution are simultaneously added dropping to a reaction container. The raw material monomer solution may include a basic reaction aid as necessary.

As a solvent for the oxidizing agent solution and the raw material monomer solution, the above-mentioned polymerization solvent can be used.

A reaction temperature of the polymerization reaction is preferably 50°C or lower, more preferably -15 to 30°C, and still more preferably -10 to 20°C. When the reaction temperature of the polymerization reaction is 50°C or lower, in particular, 30°C or lower, the progress of side reactions and decrease in conductivity due to a change in the redox structure of the main chain of the generated conductive polymer (A) can be suppressed. When the reaction temperature of the polymerization reaction is -15°C or higher, a sufficient reaction rate can be maintained and the reaction time can be shortened.

Through the polymerization step, the conductive polymer (A), which is the reaction product, is obtained in a state of being dissolved or precipitated in a polymerization solvent.

When the reaction product is dissolved in a polymerization solvent, the polymerization solvent is distilled off to obtain a reaction product.

When the reaction product is precipitated in a polymerization solvent, the polymerization solvent is filtered out by a filter such as a centrifuge to obtain a reaction product.

In the reaction products, low-molecular-weight components such as unreacted raw material monomers, oligomers accompanying the resulting side reactions, acidic substances (free acid groups eliminated from the conductive polymer (A), sulfate ions which are decomposition products of oxidizing agents, and the like), and basic substances (basic reaction aids, ammonium ions which are decomposition products of oxidizing agents, and the like) may be included. These low-molecular-weight components are impurities and cause interference of the conductivity.

Thus, it is preferable to purify the reaction product to remove the low-molecular-weight components.

### <<Purification Step>>

The purification step is a step of purifying the reaction product obtained in the polymerization step.

As a method for purifying the reaction product, any of methods such as a washing method using a washing solvent, a membrane filtration method, an ion exchange method, removal of impurities by a heat treatment, and neutralization precipitation can be used. Among these, the washing method and the ion exchange method are effective from the viewpoint that the conductive polymer (A) with high purity can be easily obtained. In particular, from the viewpoint that raw material monomers, oligomers, acidic substances, and the like can be efficiently removed, the washing method is preferable. From the viewpoint that basic substances present in a state of forming a salt with the acidic group of the conductive polymer (A), and the like can be efficiently removed, the ion exchange method is preferable. In the purification step, a combination of the washing method and the ion exchange method may be used.

Examples of washing solvents include alcohols such as methanol, ethanol, n-propanol, isopropanol, n-butanol, isobutanol, 2-butanol, 3-butanol, t-butanol, 1-pentanol, 3-methyl-1-butanol, 2-pentanol, n-hexanol, 4-methyl-2-pentanol, 2-ethylbutynol, benzyl alcohol, furfuryl alcohol, and tetrahydrofurfuryl alcohol; polyhydric alcohol derivatives such as ethylene glycol monomethyl ether, ethylene glycol monoethyl ether, methoxy methoxyethanol, propylene glycol monoethyl ether, and glyceryl monoacetate; acetone, acetonitrile, N,N-dimethylformamide, N-methylpyrrolidone, and dimethyl sulfoxide. Among these, methanol, ethanol, isopropanol, acetone, and acetonitrile are effective.

When the reaction product after washing, that is, the conductive polymer (A) after washing is dried, the conductive polymer (A) in solid form can be obtained.

Examples of ion exchange methods include column type or batch type treatments using ion exchange resins such as cation exchange resins and anion exchange resins; and electrodialysis methods.

When the reaction product is dissolved in the polymerization solvent, the contact may be performed with the ion exchange resin as it is in the dissolved state. When the concentration of the reaction product is high, dilution may be performed with an aqueous medium.

When the reaction product is precipitated in the polymerization solvent, it is preferable that a polymer solution, in which the reaction product is dissolved in an aqueous medium to the desired solid concentration after filtration of the polymerization solvent, be prepared and brought into contact with the ion exchange resin.

When the reaction product after washing is subjected to an ion exchange treatment, it is preferable that a polymer solution, in which the reaction product after washing is dissolved in an aqueous medium to the desired solid concentration, be prepared and brought into contact with the ion exchange resin.

Examples of the aqueous medium include the same as those of the solvent (D), which will be described later.

The concentration of the conductive polymer (A) in the polymer solution is preferably 0.1% to 20% by mass, and more preferably 0.1% to 10% by mass from the viewpoint of industrial efficiency and purification efficiency.

In an ion exchange method using an ion exchange resin, the amount of the sample solution with respect to the ion exchange resin is preferably up to 10 times the volume, and more preferably up to 5 times the volume with respect to the ion exchange resin, for example, for a polymer solution with a solid concentration of 5% by mass. Examples of the cation exchange resin include "Amberlite IR-120B" manufactured by Organo Corporation. Examples of the anion exchange resin include "Amberlite IRA410" manufactured by Organo Corporation.

The conductive polymer (A) after the ion exchange treatment is in a state of being dissolved in the polymerization solvent or aqueous medium. Accordingly, when all of the polymerization solvent or aqueous medium is removed by an evaporator or the like, the solid conductive polymer (A) can be obtained, but the conductive polymer (A) may be used for the production of conductive compositions in a state of being dissolved in the polymerization solvent or aqueous medium.

### (Basic Compound (B))

When the conductive polymer (A) has an acidic group, it is considered that when the conductive composition includes the basic compound (B), the basic compound (B) efficiently acts on the acidic group in the conductive polymer (A), thereby making it possible to improve the stability of the conductive polymer (A). Here, efficient action on the acidic group in the conductive polymer (A) means that the conductive polymer (A) can be stably neutralized and a stable salt is formed between the acidic group in the conductive polymer (A) and the basic compound (B). That is, the conductive polymer (A) is neutralized with the basic compound (B). As a result, the instability of the acidic group of the conductive polymer (A) due to hydrolysis in the conductive composition can be suppressed and the acidic group is less likely to be eliminated. By forming a stable salt between the acidic group of the conductive polymer (A) and the basic compound (B), the decomposition of the conductive polymer (A) can also be suppressed. Moreover, the basic compound (B) also forms a stable salt with a decomposition product (for example, a sulfate ion) of the oxidizing agent used for the production of the conductive polymer (A). Therefore, the generation of an acidic group derived from the conductive polymer (A) and a sulfate ion derived from the oxidizing agent in the conductive composition can be suppressed. The contained amount of the decomposition product of the conductive polymer (A) in the conductive composition can also be reduced.

Therefore, particularly in a pattern-forming method by ionizing radiation using a chemical amplification type resist, migration from the conductive film such as an acidic substance to the resist layer side is suppressed and the effects of a reduction in the film thickness of the resist layer and the like can be suppressed.

The basic compound (B) is not particularly limited as long as it is a compound having basicity, and examples thereof include a quaternary ammonium compound (b-1), a basic compound (b-2), a basic compound (b-3), and a basic compound (b-4).

Quaternary ammonium compound (b-1): A quaternary ammonium compound in which at least one of the four substituents bonded to the nitrogen atom is a hydrocarbon group with one or more carbon atoms.

Basic compound (b-2): A basic compound having one or more nitrogen atoms (provided that the quaternary ammonium compound (b-1) and the basic compound (b-3) are excluded).

Basic compound (b-3): A basic compound having a basic group and two or more hydroxy groups in the same molecule and a melting point of 30°C or higher.

Basic compound (b-4): An inorganic base.

In the quaternary ammonium compound (b-1), the nitrogen atom to which the four substituents are bonded is the nitrogen atom of the quaternary ammonium ion.

Examples of the hydrocarbon group bonded to the nitrogen atom of the quaternary ammonium ion in the quaternary ammonium compound (b-1) include an alkyl group, an aralkyl group, and an aryl group.

Examples of the quaternary ammonium compound (b-1) include tetramethylammonium hydroxide, tetraethylammonium hydroxide, tetrapropylammonium hydroxide, tetrabutylammonium hydroxide, tetrapentylammonium hydroxide, tetrahexylammonium hydroxide, and benzyltrimethylammonium hydroxide.

Examples of the basic compound (b-2) include ammonia, pyridine, 4-dimethylaminopyridine, 4-dimethylaminomethylpyridine, 3,4-bis(dimethylamino)pyridine, picoline, triethylamine, 4-dimethylaminopyridine, 4-dimethylaminomethylpyridine, 3,4-bis(dimethylamino)pyridine, 1,5-diazabicyclo[4.3.0]-5-nonene (DBN), 1,8-diazabicyclo[5.4.0]-7-undecene (DBU), 1-(3-aminopropyl)-2-pyrrolidone, N-(3-aminopropyl)-ε-caprolactam, and derivatives thereof.

Examples of the basic group in the basic compound (b-3) include basic groups defined as Arrhenius bases, Brønsted bases, and Lewis bases. A specific example thereof is ammonia. The hydroxy group may be in a state of -OH or may be in a state of being protected by a protecting group. Examples of the protecting group include an acetyl group; silyl groups such as a trimethylsilyl group and a t-butyldimethylsilyl group; acetal-type protecting groups such as a methoxymethyl group, an ethoxymethyl group, and a methoxyethoxymethyl group; a benzoyl group; and an alkoxide group.

Examples of the basic compound (b-3) include 2-amino-1,3-propanediol, tris(hydroxymethyl)aminomethane, 2-amino-2-methyl-1,3-propanediol, 2-amino-2-ethyl-1,3-propanediol, 3-[N-tris(hydroxymethyl)methylamino]-2-hydroxypropanesulfonic acid, and N-tris(hydroxymethyl)methyl-2-aminoethanesulfonic acid.

Examples of the basic compound (b-4) include sodium hydroxide, potassium hydroxide, and lithium hydroxide.

Any one of these basic compounds (B) may be used alone, or two or more kinds thereof may be mixed in any proportion and used.

### (Surfactant (C))

When the conductive composition includes a surfactant (C), the coating property upon the application of the conductive composition onto a surface of a base material or a resist layer is improved.

Examples of the surfactant (C) include anionic surfactants, cationic surfactants, amphoteric surfactants, and non-ionic surfactants. Any one of these surfactants may be used alone, or two or more kinds thereof may be mixed in any proportion and used.

Examples of the anionic surfactants include sodium dialkylsulfosuccinate, sodium octanoate, sodium decanoate, sodium laurate, sodium myristate, sodium palmitate, sodium stearate, perfluorononanoic acid, N-sodium lauroyl sarcosine, sodium cocoyl glutamate, alpha sulfo fatty acid methyl ester salts, sodium lauryl sulfate, sodium myristyl sulfate, sodium laureth sulfate, sodium polyoxyethylene alkyl phenol sulfonate, ammonium lauryl sulfate, lauryl phosphate, sodium lauryl phosphate, and potassium lauryl phosphate.

Examples of the cationic surfactants include tetramethylammonium chloride, tetramethylammonium hydroxide, tetrabutylammonium chloride, dodecyldimethylbenzylammonium chloride, alkyltrimethylammonium chloride, octyltrimethylammonium chloride, decyltrimethylammonium chloride, dodecyltrimethylammonium chloride, tetradecyltrimethylammonium chloride, cetyltrimethylammonium chloride, stearyltrimethylammonium chloride, alkyltrimethylammonium bromide, hexadecyltrimethylammonium bromide, benzyltrimethylammonium chloride, benzyltriethylanunonium chloride, benzalkonium chloride, benzalkonium bromide, benzethonium chloride, dialkyl dimethylammonium chloride, didecyl dimethylammonium chloride, distearyl dimethylammonium chloride, monomethylamine hydrochloride, dimethylamine hydrochloride, trimethylamine hydrochloride, butylpyridinium chloride, dodecylpyridinium chloride, and cetylpyridinium chloride.

Examples of the amphoteric surfactants include lauryl dimethylamino acetate betaine, stearyl dimethylamino acetate betaine, dodecylamino methyl dimethyl sulfopropyl betaine, octadecylamino methyl dimethyl sulfopropyl betaine, cocamidopropyl betaine, cocamidopropyl hydroxysultaine, 2-alkyl-N-carboxymethyl-N-hydroxyethyl imidazolinium betaine, sodium lauroyl glutamate, potassium lauroyl glutamate, lauroyl methyl-β-alanine, lauryl dimethylamine N-oxide, and oleyl dimethylamine N-oxide.

Examples of the non-ionic surfactants include glycerol laurate, glycerol monostearate, sorbitan fatty acid esters, sucrose fatty acid esters, polyoxyethylene alkyl ethers, pentaethylene glycol monododecyl ether, octaethylene glycol monododecyl ether, polyoxyethylene alkyl phenyl ether, octylphenol ethoxylate, nonylphenol ethoxylate, polyoxyethylene polyoxypropylene glycol, polyoxyethylene sorbitan fatty acid esters, polyoxyethylene hexitan fatty acid esters, sorbitan fatty acid esters polyethylene glycol, lauric acid diethanolamide, oleic acid diethanolamide, stearic acid diethanolamide, octyl glucoside, decyl glucoside, lauryl glucoside, cethanol, stearyl alcohol, and oleyl alcohol.

As the non-ionic surfactant, a water-soluble polymer having a nitrogen-containing functional group and a terminal hydrophobic group may be used in addition to the above-described non-ionic surfactants. Unlike the surfactants of the related art, the water-soluble polymer has surfactant performance due to the main chain part (hydrophilic part) having a nitrogen-containing functional group and the terminal hydrophobic group part and is highly effective in improving the coating property. Thus, it is possible to impart excellent coating properties to the conductive composition without the use in combination with other surfactants. Moreover, this water-soluble polymer does not include acids or bases, and does not easily produce by-products due to hydrolysis, thus, adverse effects on the resist layer and the like are particularly low.

As the nitrogen-containing functional group, an amide group is preferable from the viewpoint of solubility.

Examples of the terminal hydrophobic group include alkyl groups, aralkyl groups, aryl groups, alkoxy groups, aralkyloxy groups, aryloxy groups, alkylthio groups, aralkylthio groups, arylthio groups, primary or secondary alkylamino groups, aralkylamino groups, and arylamino groups. Among these, alkylthio groups, aralkylthio groups, and arylthio groups are preferable.

The number of carbon atoms of the terminal hydrophobic group is preferably 7 to 100, more preferably 7 to 50, and particularly preferably 10 to 30.

The number of terminal hydrophobic groups in the water-soluble polymer is not particularly limited. When two or more terminal hydrophobic groups are contained in the same molecule, the terminal hydrophobic groups may be the same kind or different kinds.

As the water-soluble polymer, it is preferable to use a compound which has a main chain structure of a homopolymer of a vinyl monomer having a nitrogen-containing functional group or a copolymer of a vinyl monomer having a nitrogen-containing functional group and a vinyl monomer not having a nitrogen-containing functional group (other vinyl monomer), and which has hydrophobic groups at sites other than the repeating units forming the polymer.

Examples of the vinyl monomer having a nitrogen-containing functional group include acrylamide and derivatives thereof and heterocyclic monomers having a nitrogen-containing functional group, among which examples having an amide bond are preferable. Specific examples thereof include acrylamide, N,N-dimethylacrylamide, N-isopropylacrylamide, N,N-diethylacrylamide, N,N-dimethylaminopropylacrylamide, t-butylacrylamide, diacetoneacrylamide, N,N'-methylenebisacrylamide, N-vinyl-N-methylacrylamide, N-vinylpyrrolidone, and N-vinylcaprolactam. Among these, acrylamide, N-vinylpyrrolidone, N-vinylcaprolactam, and the like are particularly preferable from the viewpoint of solubility.

Other vinyl monomers are not particularly limited as long as they can be copolymerized with vinyl monomers having a nitrogen-containing functional group and examples thereof include styrene, acrylic acid, vinyl acetate, and long-chain α-olefins.

A method for introducing a terminal hydrophobic group into a water-soluble polymer is not particularly limited, but usually, introduction by selecting a chain transfer agent during vinyl polymerization is convenient and preferable. In such a case, the chain transfer agent is not particularly limited as long as a group including a hydrophobic group such as an alkyl group, an aralkyl group, an aryl group, an alkylthio group, an aralkylthio group, or an arylthio group is introduced at a terminal of the obtained polymer. For example, when obtaining a water-soluble polymer having an alkylthio group, an aralkylthio group, or an arylthio group as a terminal hydrophobic group, it is preferable to perform the vinyl polymerization using a chain transfer agent having a hydrophobic group corresponding to the terminal hydrophobic group, specifically a thiol, a disulfide, a thioether, or the like. Examples of such a chain transfer agent include n-dodecyl mercaptan, t-dodecyl mercaptan, n-octyl mercaptan, 2-ethylhexyl mercaptan, and n-octadecyl mercaptan. These may be used alone or in combination of two or more kinds thereof.

As a polymerization initiator used during the vinyl polymerization, an azobis-methylbutyronitrile or a polymerization initiator having a terminal hydrophobic group.

Examples of the polymerization initiator having a terminal hydrophobic group include those having a linear or branched alkyl group having 6 to 20 carbon atoms and not having a cyano group and a hydroxy group, and specific examples thereof include dilauroyl peroxide, 1,1,3,3-tetramethylbutylhydroperoxide, di-t-hexyl peroxide, di(2-ethylhexyl)peroxydicarbonate, 1,1,3,3-tetramethylbutylperoxyneodecanoate, and di(3,5,5-trimethylhexanoyl)peroxide. These may be used alone or in combination of two or more kinds thereof.

The main chain part of the water-soluble polymer is water-soluble and a nitrogen-containing functional group. The number of units (degree of polymerization) of the main chain part is preferably 2 to 1,000 in one molecule, more preferably 2 to 100, and particularly preferably 2 to 50. When the number of units of the main chain part having a nitrogen-containing functional group is too large, the interfacial performance tends to deteriorate.

A molecular weight ratio of the main chain part in the water-soluble polymer to the terminal hydrophobic group part (for example, an alkyl group, an aralkyl group, an aryl group, an alkylthio group, an aralkylthio group, and an arylthio group) (the mass-average molecular weight of the main chain part/the mass-average molecular weight of the terminal hydrophobic group part) is preferably 0.3 to 170.

In terms of the polyethylene glycol equivalent in GPC, the mass-average molecular weight of the water-soluble polymer is preferably 100 to 1,000,000, more preferably 100 to 100,000, still more preferably 600 or more and less than 2,000, and particularly preferably 600 to 1,800. When the mass-average molecular weight of the water-soluble polymer is equal to or more than the lower limit value, the coating property of the conductive composition is increased. On the other hand, when the mass-average molecular weight of the water-soluble polymer is equal to or less than the upper limit value, the water solubility of the conductive composition is increased. **In** particular, when the mass-average molecular weight of the water-soluble polymer is 600 or more and less than 2,000, a balance between practical water solubility and coating property is excellent.

As the surfactant (C), non-ionic surfactants are preferable from the viewpoint of having less influence on the resist layer, and among these, a water-soluble polymer having a nitrogen-containing functional group and a terminal hydrophobic group is particularly preferable.

### (Solvent (D))

The solvent (D) is not particularly limited as long as it is a solvent capable of dissolving at least the conductive polymer (A) and has the effect of the present invention, and examples thereof include water, an organic solvent, and a mixed solvent of water and the organic solvent.

Examples of the water include water among the polymerization solvents exemplified above in the description of the method for producing the conductive polymer (A).

Examples of the organic solvent include any of the organic solvents among the polymerization solvents exemplified above in the description of the method for producing the conductive polymer (A).

When the mixed solvent of water and the organic solvent is used as the solvent (C), a mass ratio of these solvents (water/the organic solvent) is preferably 1/100 to 100/1, and more preferably 2/100 to 100/2.

### (Optional Components)

Examples of the optional components include polymer compounds (provided that the conductive polymer (A), the basic compound (B), and the surfactant (C) are excluded), and an additive.

Examples of the polymer compounds include polyvinyl alcohol derivatives such as polyvinyl formal and polyvinyl butyral and modified products thereof, starch and modified products thereof (starch oxide, phosphate esterified starch, cationized starch, and the like), cellulose derivatives (carboxymethyl cellulose, methylcellulose, hydroxypropyl cellulose, hydroxyethylcellulose, salts thereof, and the like), polyacrylamides such as polyacrylamide, poly(N-t-butylacrylamide), and polyacrylamidomethylpropanesulfonic acid, polyvinylpyrrolidone, polyacrylic acids (salts), polyethylene glycol, water-soluble alkyd resins, water-soluble melamine resins, water-soluble urea resins, water-soluble phenolic resins, water-soluble epoxy resins, water-soluble polybutadiene resins, water-soluble acrylic resins, water-soluble urethane resins, water-soluble acrylstyrene copolymer resins, water-soluble vinyl acetate acrylic copolymer resins, water-soluble polyester resins, water-soluble styrene-maleic acid copolymerized resins, water-soluble fluororesins, and copolymers thereof.

Examples of the additive include a pigment, a defoamer, an ultraviolet absorber, an antioxidant, a heat resistance improver, a leveling agent, an anti-sagging agent, a matting agent, and a preservative.

### (Contained Amount)

The contained amount of the conductive polymer (A) is preferably 0.1% to 5% by mass, more preferably 0.2% to 3% by mass, and still more preferably 0.5% to 2% by mass with respect to the total mass of the conductive composition.

The contained amount of the conductive polymer (A) is preferably 50% to 99.9% by mass, more preferably 80% to 99.9% by mass, and still more preferably 95% to 99.9% by mass with respect to the total mass of the solid content of the conductive composition. The solid content of the conductive composition is the remainder of the conductive composition excluding the solvent (D).

When the contained amount of the conductive polymer (A) is within the range, there is an excellent balance between the coating property of the conductive composition and the conductivity of the conductive film formed from the conductive composition.

The contained amount of the basic compound (B) is preferably 5 to 80 parts by mass, more preferably 5 to 50 parts by mass, and still more preferably 5 to 30 parts by mass with respect to 100 parts by mass of the conductive polymer (A). When the contained amount of the basic compound (B) is equal to or more than the lower limit value, even though the conductive polymer (A) includes an acidic group, the acidic group of the conductive polymer (A) can sufficiently form a salt with the oxidizing agent, and the acidic group is less likely to be eliminated. The basic compound (B) also sufficiently forms a salt with a decomposition product of the oxidizing agent. Thus, the migration of the acidic group and the decomposition product of the oxidizing agent to the resist layer is suppressed and a reduction in the film thickness of the resist layer can be suppressed. When the contained amount of the basic compound (B) is equal to or less than the upper limit value, the contained amount of the conductive polymer (A) in the conductive composition can be sufficiently secured, and thus, a conductive film having favorable conductivity can be formed. When the conductive polymer (A) includes an acidic group, the acidic group is moderately present in a free state without forming salts with the basic compound (B) in the conductive film, and thus, the conductivity can be favorably maintained. In particular, when the conductive polymer (A) has an acidic group or a salt thereof, the contained amount of the basic compound (B) is preferably 0.1 to 1 molar equivalent, and more preferably 0.1 to 0.9 molar equivalents with respect to 1 mol of the units having an acidic group among the units constituting the conductive polymer (A) from the viewpoint of further improving the coatability of the conductive composition. The contained amount of the acidic group is particularly preferably 0.25 to 0.85 molar equivalents from the viewpoint of having excellent retention of the performance as a conductive film and making it possible to further stabilize the acidic group in the conductive polymer (A).

The contained amount of the surfactant (C) is preferably 5 to 200 parts by mass, and more preferably 10 to 100 parts by mass with respect to 100 parts by mass of the conductive polymer (A). When the contained amount of the surfactant (C) is within the range, the coating property of the conductive composition onto the resist layer is further improved.

The contained amount of the solvent (D) is preferably 1% to 99% by mass, more preferably 10% to 98% by mass, and still more preferably 50% to 98% by mass with respect to the total mass of the conductive composition. When the contained amount of the solvent (D) is within the range, the coating property is further improved.

When the conductive polymer (A) is used in a state of being dispersed or dissolved in an aqueous medium by purification or the like (in which the conductive polymer (A) in this state is hereinafter also referred to as a "conductive polymer solution"), the aqueous medium derived from the conductive polymer solution is also included in the contained amount of the solvent (D) in the conductive composition.

The total amount of all the components constituting the conductive composition does not exceed 100% by mass.

### (Method for Producing Conductive Composition)

The conductive composition is obtained, for example, by mixing the above-described conductive polymer (A) and solvent (D), and as necessary, one or more of the basic compound (B), the surfactant (C), and the optional components.

For example, since the conductive polymer (A) after washing, produced by the above-described method for producing the conductive polymer (A), is in solid form, the conductive composition may be obtained by mixing the conductive polymer (A) in solid form and the solvent (D), and as necessary, one or more of the basic compound (B), the surfactant (C), and the optional components.

When the conductive polymer (A) further purified by the ion exchange method after washing is used, the conductive polymer (A) after the ion exchange treatment is obtained in a state of the conductive polymer solution as described above. Therefore, the conductive polymer solution may be used as it is as the conductive composition or the conductive polymer solution may be diluted with the solvent (D). One or more of the basic compound (B), the surfactant (C), and the optional components may be added to the conductive polymer solution as necessary to obtain a conductive composition, or the conductive polymer solution may be further diluted with the solvent (D).

### <Action Effect>

In the method for producing a conductive film of the present invention described above, a defect of the conductive film is inspected by irradiating a conductive film with a laser having a wavelength at which the attenuation coefficient k of the conductive film is 0.2 or less. Thus, the conductive film is less likely to absorb the laser, and when a defect is present in the conductive film, the defect is likely to be detected and the detection accuracy is high. Therefore, according to the method for producing a conductive film of the present invention, it is possible to provide a high-quality conductive film and a base material with a conductive film.

### <Use>

The method for producing a conductive film of the present invention can be applied to, for example, a method for producing a mask blank with a conductive film, a method for producing a mask, and a method for producing a semiconductor device.

### [Method for Producing Mask Blank with Conductive Film]

An embodiment of a method for producing a mask blank with a conductive film will be described.

The method for producing a mask blank with a conductive film of the present embodiment includes a step of forming a conductive film on a mask blank using the above-described method for producing a conductive film of the present invention.

Specifically, the method is as follows.

First, the mask blank is used as a base material and a conductive film is formed on the mask blank, thereby obtaining a mask blank with a conductive film. A method for forming the conductive film is the same as the above-described film formation step.

It is preferable that a resist layer be formed on the mask blank before the conductive film is formed on the mask blank. That is, it is preferable that the conductive film be formed on the resist layer of the mask blank on which the resist layer is formed. A method for forming the resist layer is the same as the above-described resist layer formation step.

As the mask blank, a known mask blank can be used and a mask blank corresponding to the configuration of the target mask may be used. Specific examples of the mask blank include those provided with a light-transmitting substrate and a thin film provided on the light-transmitting substrate.

Examples of the light-transmitting substrate include soda-lime glass, low expansion glass, and quartz glass.

Examples of the thin film include a light-shielding film, an antireflection film, a phase shift film, and an antioxidant film. The thin film may have a monolayer structure or a multilayer structure.

Next, after forming a conductive film on the mask blank, the mask blank is irradiated with a laser to inspect a defect of the mask blank. The defect inspection method is the same as the above-described inspection step.

It is preferable that the wavelength of the laser to be applied to the mask blank be determined based on the attenuation coefficient k of the conductive film before inspecting the defect of the mask blank.

In the method for producing a mask blank with a conductive film of the present embodiment described above, a defect of the mask blank is inspected by irradiating the mask blank with a laser having a wavelength at which the attenuation coefficient k of the conductive film is 0.2 or less. Thus, the conductive film is less likely to absorb the laser, and when the defect is present in the mask blank, the defect is likely to be detected and the detection accuracy is high. Therefore, according to the method for producing a mask blank with a conductive film of the present embodiment, a high-quality mask blank with a conductive film can be provided.

### [Method for Producing Mask]

An embodiment of a method for producing a mask of the present invention will be described.

The method for producing a mask of the present embodiment includes a step of producing a mask blank with a conductive film and a step of producing a mask using the obtained mask blank with a conductive film.

Specifically, the method is as follows.

First, a mask blank with a conductive film is produced. For example, the mask blank with a conductive film may be produced by forming a conductive film on a mask blank using the above-described method for producing a conductive film of the present invention, or the mask blank with a conductive film may be produced using the above-described method for producing a mask blank with a conductive film.

It is preferable that a resist layer be formed on the mask blank before the conductive film is formed on the mask blank. That is, it is preferable to produce a mask using a mask blank with a conductive film, in which the resist layer and the conductive film are formed in this order on the mask blank.

The mask blank with a conductive film obtained in this manner is obtained by inspecting a defect of the mask blank.

Next, a mask is produced using the mask blank with a conductive film, which has been subjected to defect inspection, that is, a mask blank with a conductive film, which has been determined to be acceptable by defect inspection for the mask blank. The step of producing a mask includes, for example, an ionizing radiation irradiation step, a water washing and development step, an etching step, and a resist layer removal step, each shown below.

The ionizing radiation irradiation step is a step of irradiating the resist layer of the mask blank with a conductive film with ionizing radiation in a patterned manner. Specifically, the mask blank with a conductive film is irradiated with ionizing radiation from the side of the conductive film.

Examples of the ionizing radiation include charged particle beams such as electron beams and ion beams; and electromagnetic waves such as X rays and gamma rays.

In the ionizing radiation irradiating step, a latent image is formed in the resist layer between the mask blank and the conductive film. When the resist layer consists of a chemical amplification type resist, an acid is generated from the acid generator in the ionizing radiation irradiation unit.

Since the conductive film is provided on the surface of the resist layer, grounding can be taken from the conductive film and the entire mask blank with the conductive film can be prevented from being charged. Therefore, a shift of the positions of electrons incident on the resist layer due to an influence of the charging can be suppressed and a latent image corresponding to the target resist pattern can be formed with a high accuracy.

The water washing and development step is a step of removing the conductive film by subjecting the resist layer to water washing and development to form a resist pattern.

Since the conductive film is water-soluble, the conductive film is dissolved and removed when the water washing is performed.

The water washing represents bringing into contact with an aqueous liquid. Examples of the aqueous liquid include simple water, water including at least one of a base and a basic salt, water including an acid, and a mixture of water and a water-soluble organic solvent.

When the positive tone resist layer is developed, the portion of the positive tone resist layer irradiated with ionizing radiation is dissolved and removed, and a resist pattern consisting of a portion of the positive tone resist layer which not irradiated with ionizing radiation is formed.

On the other hand, when the negative tone resist layer is developed, unlike the case of the positive tone resist layer, the portion which has not been irradiated with ionizing radiation is dissolved and removed, and a resist pattern consisting of the portion of the negative tone resist layer irradiated with ionizing radiation is formed.

The water washing and development step can be performed, for example, by the following method (α) or (β).

Method (α): A resist layer is developed while removing the conductive film, using an alkaline developing solution for water washing.

Method (β): Only the conductive film is removed by water washing and then the resist layer is developed with a developing solution.

The alkaline developing solution (aqueous alkaline solution) used in the method (α) is not particularly limited, and any known alkaline developing solution can be used. Examples thereof include an aqueous tetramethylammonium hydroxide solution.

The water washing in the method (β) can be performed using an aqueous solution not corresponding to a developing solution, for example, water. The development can be performed using an alkaline developing solution in the same manner as in the method (α).

After the water washing and development step, the substrate may be subjected to a rinsing treatment with pure water or the like, as necessary.

After the water washing and development step or after the rinsing treatment, the substrate on which the resist pattern is formed may be heated (post-baked), as necessary.

The etching step is a step of etching a thin film of a mask blank, using a resist pattern as a mask. By the etching, a thin film of a part which is not masked by the resist pattern is removed (that is, an exposed part).

As the etching method, a known method can be adopted, and examples thereof include dry etching and wet etching.

The resist removal step is a step of removing a resist pattern remaining on the mask blank after the etching. By removing the resist pattern, a mask (photomask) on which a pattern is formed is obtained.

A known peeling agent can be used for removing the resist pattern.

The method for producing a mask of the present embodiment may further include a step of inspecting a defect on a mask blank, which is a base material, by laser irradiation after the conductive film has been removed (hereinafter also referred to as a "second inspection step"). That is, the second inspection step is a step of inspecting a defect on the mask blank, from which the conductive film has been removed, by laser irradiation.

The second inspection step may be provided between the water washing and development step and the etching step, between the etching step and the resist removal step, or after the resist removal step. In addition, when the water washing and development step is performed by the method (β), the second inspection step may be performed between the water washing step and the development step.

The wavelength of the laser used in the second inspection step is not particularly limited.

Specifically, a defect on the mask blank after the conductive film has been removed is detected as follows.

First, the mask blank is irradiated with a laser. When the resist layer remains on the mask blank, it is irradiated with a laser.

When a defect is present on the mask blank after the conductive film has been removed, the laser which has hit the defect is scattered. By detecting the scattered laser with a detector, a defect on the mask blank after the conductive film has been removed, that is, a defect on the base material is detected.

Since the method for producing a mask of the present invention described above uses the mask blank with a conductive film obtained by the method for producing a mask blank with a conductive film of the present invention described above, the accuracy in defect detection is high and a high-quality mask can be provided.

### [Method for Producing Semiconductor Device]

One embodiment of a method for producing a semiconductor device of the present invention will be described.

The method for producing a semiconductor device of the present embodiment includes a step of forming a conductive film on a base material using the above-described method for producing a conductive film of the present invention to obtain a laminate and a step of producing a semiconductor device using the laminate.

Specifically, the method is as follows.

First, a conductive film is formed on a base material to obtain a laminate. A method for forming the conductive film is the same as the above-described film formation step.

It is preferable that a resist layer be formed on a base material before the conductive film is formed on the base material. That is, it is preferable that a conductive film be formed on the resist layer of the base material with a resist layer using the base material with a resist layer, and a semiconductor device is produced using a laminate in which the resist layer and the conductive film are formed in this order on the base material. A method for forming the resist layer is the same as the above-described resist layer formation step.

As the base material, a known base material used as a base material for a semiconductor device can be used. Examples thereof include a silicon wafer.

Next, after forming a conductive film on the base material, the conductive film formed on the base material is irradiated with a laser to inspect a defect of the mask blank. The defect inspection method is the same as the above-described inspection step.

It is preferable that the wavelength of the laser to be applied to the mask blank be determined based on the attenuation coefficient k of the conductive film before the defect of the conductive film is inspected.

The laminate obtained in this manner is obtained by inspecting the defect of the mask blank.

Next, a semiconductor device is produced using the laminate subjected to defect inspection, that is, the laminate is determined to be acceptable by the defect inspection for the mask blank. The step of producing a semiconductor device includes, for example, an ionizing radiation irradiation step shown below. In addition, the method further includes a water washing step, a development step, an etching step, and a resist layer removal step, each shown below, as necessary.

The ionizing radiation irradiation step is a step of irradiating the laminate with ionizing radiation such as electron beams and ion beams to form a wiring pattern.

Since a conductive film is provided on a surface of the base material or the resist layer, it is possible to ground the entire laminate from the conductive film and to prevent the entire laminate from being charged. Therefore, a shift of the positions of electrons incident on the base material or the resist layer due to an influence of the charging can be suppressed and a latent image corresponding to the transferred resist pattern can be formed with a high accuracy.

The water washing step and the development step are the same as the water washing and development step in the above-described method for producing a mask. The water washing step and the development step may be performed at the same time (the method (α)), or the development step may be performed after the water washing step (the method (β)).

The etching step is the same as the etching step in the above-described method for producing a mask.

The resist layer removal step is the same as the resist layer removal step of the above-described method for producing a mask.

The method for producing a semiconductor device of the present embodiment may further include a step of inspecting a defect on the base material by laser irradiation after the conductive film has been removed (hereinafter also referred to as a "third inspection step"). That is, the third inspection step is a step of inspecting a defect on the base material, from which the conductive film has been removed, by laser irradiation.

The third inspection step may be performed between the water washing step and the development step, between the development step and the etching step, between the etching step and the resist removal step, or after the resist removal step.

In the method for producing a semiconductor device of the present invention described above, a defect of the conductive film is inspected by irradiating a conductive film with a laser having a wavelength at which the attenuation coefficient k of the conductive film is 0.2 or less. Thus, the conductive film is less likely to absorb the laser, and when the defect is present in the conductive film, the defect is likely to be detected and the detection accuracy is high. Therefore, according to the method for producing a semiconductor device of the present invention, a high-quality semiconductor device can be provided.

### [Examples of Attenuation Coefficient]

Attenuation coefficients at specific wavelengths of a 30 nm conductive film including polyaniline sulfonic acid, measured with an ultraviolet-visible spectrophotometer, are shown in Table 1. It is considered that when the attenuation coefficient of the conductive film is 0.20 or less, the absorption of the laser is suppressed and the defect is likely to be detected.

**[Table 1]**

| Wavelength (nm) | Attenuation coefficient |
|---|---|
| 550 | 0.03 |
| 650 | 0.03 |
| 800 | 0.01 |

### REFERENCE SIGNS LIST

1, 2: Laminate
11: Base material
12: Conductive film
13: Resist layer

## Claims

1. A method for producing a conductive film, the method comprising:
an inspection step of inspecting a defect of a conductive film by irradiating the conductive film with a laser,
wherein in the inspection step, the conductive film is irradiated with a laser having a wavelength at which an attenuation coefficient k of the conductive film is 0.2 or less.

2. The method for producing a conductive film according to Claim 1, the method further comprising:
a film formation step of forming the conductive film on a base material.

3. The method for producing a conductive film according to Claim 2,
wherein a resist layer is formed on the base material, and
the film formation step is a step of forming the conductive film on the resist layer.

4. The method for producing a conductive film according to Claim 1, the method further comprising:
a determination step of determining the wavelength of the laser with which the conductive film is irradiated, based on the attenuation coefficient k of the conductive film.

5. The method for producing a conductive film according to any one of Claims 1 to 4,
wherein the wavelength of the laser is 600 to 1,000 nm.

6. The method for producing a conductive film according to any one of Claims 1 to 4,
wherein the wavelength of the laser is 700 to 900 nm.

7. The method for producing a conductive film according to any one of Claims 1 to 4,
wherein the conductive film includes a conductive polymer having at least one unit selected from the group consisting of units represented by Formulae (1) to (4), 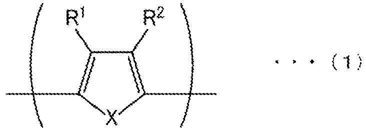 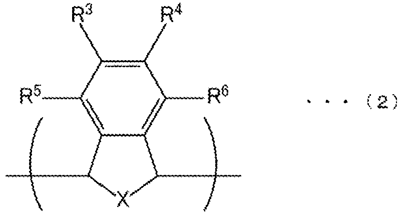 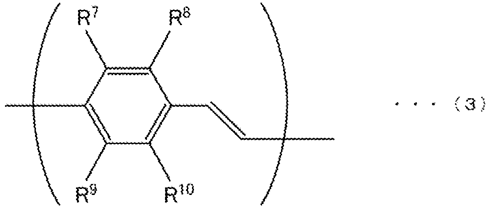 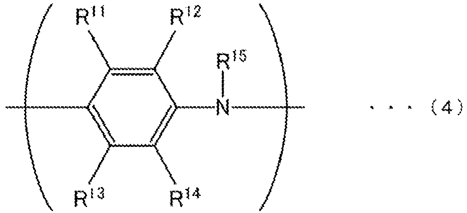
in Formulae (1) to (4), X represents a sulfur atom or a nitrogen atom, and R¹ to R¹⁵ each independently represents a hydrogen atom, a linear or branched alkyl group having 1 to 24 carbon atoms, a linear or branched alkoxy group having 1 to 24 carbon atoms, an acidic group or a salt thereof, a hydroxy group, a nitro group, a halogen atom, - N(R¹⁶)₂, -NHCOR¹⁶, -SR¹⁶, -OCOR¹⁶, -COOR¹⁶, -COR¹⁶, -CHO, or -CN, in which R¹⁶ represents an alkyl group having 1 to 24 carbon atoms, an aryl group having 6 to 24 carbon atoms, or an aralkyl group having 7 to 24 carbon atoms, provided that at least one of R¹ and R² in Formula (1), at least one of R³ to R⁶ in Formula (2), at least one of R⁷ to R¹⁰ in Formula (3), and at least one of R¹¹ to R¹⁵ in Formula (4) are each an acidic group or a salt thereof.

8. The method for producing a conductive film according to any one of Claims 1 to 4,
wherein the conductive film includes a conductive polymer having a unit represented by Formula (4), 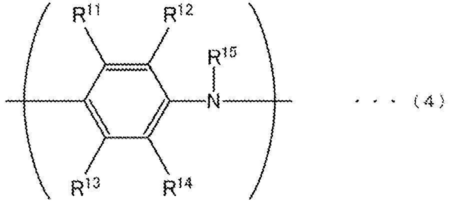
in Formula (4), R¹¹ to R¹⁵ each independently represents a hydrogen atom, a linear or branched alkyl group having 1 to 24 carbon atoms, a linear or branched alkoxy group having 1 to 24 carbon atoms, an acidic group or a salt thereof, a hydroxy group, a nitro group, a halogen atom, -N(R¹⁶ )₂, -NHCOR¹⁶, -SR¹⁶, -OCOR¹⁶, -COOR¹⁶, -COR¹⁶, - CHO, or -CN, in which R¹⁶ represents an alkyl group having 1 to 24 carbon atoms, an aryl group having 6 to 24 carbon atoms, or an aralkyl group having 7 to 24 carbon atoms, provided that at least one of R¹¹ to R¹⁵ in Formula (4) is an acidic group or a salt thereof.

9. The method for producing a conductive film according to any one of Claims 1 to 4,
wherein the conductive film includes a conductive polymer and at least one selected from the group consisting of a basic compound and a surfactant.

10. The method for producing a conductive film according to any one of Claims 1 to 4,
wherein the conductive film includes a conductive polymer having at least one unit selected from the group consisting of units represented by Formulae (1) to (4), and at least one selected from the group consisting of a basic compound and a surfactant, 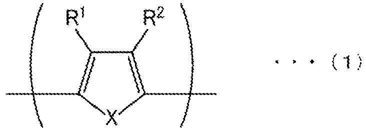 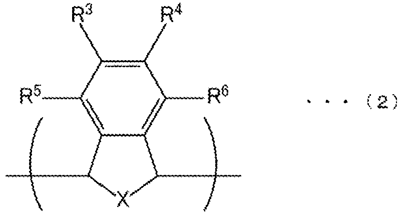 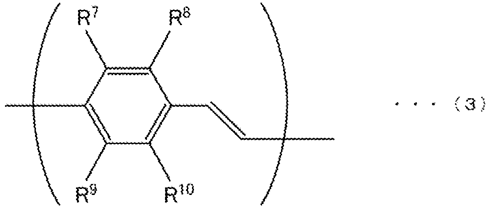 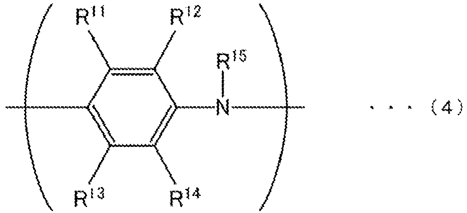
in Formulae (1) to (4), X represents a sulfur atom or a nitrogen atom, and R¹ to R¹⁵ each independently represents a hydrogen atom, a linear or branched alkyl group having 1 to 24 carbon atoms, a linear or branched alkoxy group having 1 to 24 carbon atoms, an acidic group or a salt thereof, a hydroxy group, a nitro group, a halogen atom, - N(R¹⁶)₂, -NHCOR¹⁶, -SR¹⁶, -OCOR¹⁶, -COOR¹⁶, -COR¹⁶, -CHO, or -CN, in which R¹⁶ represents an alkyl group having 1 to 24 carbon atoms, an aryl group having 6 to 24 carbon atoms, or an aralkyl group having 7 to 24 carbon atoms, provided that at least one of R¹ and R² in Formula (1), at least one of R³ to R⁶ in Formula (2), at least one of R⁷ to R¹⁰ in Formula (3), and at least one of R¹¹ to R¹⁵ in Formula (4) are each an acidic group or a salt thereof.

11. The method for producing a conductive film according to any one of Claims 1 to 4,
wherein a film thickness of the conductive film is 1 to 100 nm.

12. The method for producing a conductive film according to any one of Claims 1 to 4,
wherein a light intensity of the laser is 1 mW to 200 W.

13. A method for producing a mask, the method comprising:
a step of producing a mask blank with a conductive film using the method for producing a conductive film according to Claim 2 or 3; and
a step of producing a mask using the obtained mask blank with a conductive film.

14. The method for producing a mask according to Claim 13, the method further comprising:
a step of inspecting a defect on the mask blank, which is a base material, by laser irradiation after the conductive film has been removed from the mask blank with the conductive film.

15. A method for producing a semiconductor device, the method comprising:
a step of forming a conductive film on a base material using the method for producing a conductive film according to Claim 2 or 3 to obtain a laminate; and
a step of producing a semiconductor device using the laminate.

16. The method for producing a semiconductor device according to Claim 15, the method further comprising:
a step of inspecting a defect on the base material by laser irradiation after the conductive film has been removed.

17. A defect inspection method for a conductive film, the method comprising:
irradiating a conductive film with a laser having a wavelength at which an attenuation coefficient k of the conductive film is 0.2 or less.

18. A defect inspection device, comprising:
an irradiation unit that uses a laser having a wavelength at which an attenuation coefficient k of a conductive film is 0.2 or less for a conductive film as a measurement target; and
an inspection unit that analyzes the presence or absence of a defect based on scattered light from the conductive film.
